# EUROPEAN PATENT SPECIFICATION

(11) **EP 2 472 728 B1**
(45) Date of publication and mention of the grant of the patent: **27.11.2013**
(21) Application number: 11150092.2
(22) Date of filing: 04.01.2011
(51) Int. Cl.: H04B 1/04, H03H 7/40

(54) **Wireless communications device with an adjustable impedance matching network and associated methods**
Drahtlose Kommunikationsvorrichtung mit einem einstellbaren Impedanzanpassungsnetzwerk und zugehörige Verfahren
Dispositif de communications sans fil avec un réseau à correspondance d'impédance réglable et procédés correspondants

(43) Date of publication of application: 04.07.2012
(73) Proprietor: BlackBerry Limited, Waterloo, ON N2K 0A7 (CA)
(72) Inventor: Muhammad, Khurram, Irving, TX 75039 (US)
(74) Representative: Bryn-Jacobsen, Caelia

(56) References cited:
- EP-A2- 0 210 746
- WO-A1-2004/098076
- US-A- 3 825 825
- US-A1- 2008 090 539
- US-A1- 2008 106 349
- US-A1- 2008 158 090

## Description

### Technical Field

The present disclosure relates to the field of wireless communications, and more particularly, to antenna impedance matching in wireless communications devices.

### Background

Power amplifiers (PA) in wireless communications devices are typically designed to drive antennas at a higher power than necessary. An impedance mismatch between the antenna and the power amplifier causes standing waves at the output of the power amplifier. This reduces the total radiated power of a wireless communications device.

Load impedance variations at the antenna of the wireless communications device are caused by reflections of the radiated electromagnetic (EM) waves from objects in the vicinity of the antenna. The resulting standing waves at the output of the power amplifier can damage and reduce the total radiated power of the wireless communications device. The reflected power is expressed as a voltage standing wave ratio (VSWR), which is a ratio of the maximum to minimum amplitude (voltage or current) of the corresponding field components on the line that feeds the antenna.

To provide enough total radiated power, the power amplifier is typically over-designed to be able to provide sufficient output power to the antenna such that the total radiated power specification can be met even under poor impedance matching conditions. As a result, the power amplifier is designed to produce more output power than what it would need if the impedance match was to be perfect. This causes the efficiency of the power amplifier to be lowered at the nominal output power at the antenna as compared to another power amplifier that was designed to operate under perfect impedance matching conditions with the antenna.

One approach to address this problem is to use a programmable impedance matching network to adjust the impedance presented by the antenna. Impedance matching elements such as Barium Strontium Titanate (BST) capacitors or micro-electromechanical (MEM) capacitors may be used to provide a programmable capacitance under an applied control voltage. The applied control voltage may typically be within a range of 0-30V, for example. The DC point sets the capacitance value which can be used to create the programmable impedance matching network. The complete matching network is formed by making a pi to T network with two programmable capacitors and an inductor, or one programmable capacitor and two inductors.

Directional couplers are typically used with programmable impedance matching networks, and are placed on the path between the power amplifier and the antenna to measure forward and reflected power. Detection of the forward and reflected power is performed using log-amplifiers and non-linear detectors associated with the directional couplers. The impedance matching elements can then be adjusted to increase the forward power or reduce the reflected power. A disadvantage of directional couplers is that they are limited in dynamic range and directivity over a wide frequency band of operation. To support a wide frequency band of operation, multiple directional couplers are required. However, this increases the cost and complexity of a wireless communications device.

US3825825 relates to an automatic antenna coupler described as including a matching network having adjustable reactive elements. Control for these elements is provided by a system for detecting the real part of the complex impedance presented by the antenna or matching network. A logic and control system for adjusting the reactive elements is operated in accordance with the real part detector output so as to provide the desired impedance match.

US2008/106349 relates to an invention to which the embodiment provides an apparatus, comprising an RF matching network connected to at least one RF input port and at least one RF output port and including one or more voltage or current controlled variable reactive elements and wherein the RF matching network is adapted to maximize RF power transferred from the at least one RF input port to the at least one RF output port by varying the voltage or current to the voltage or current controlled variable reactive elements to maximize the RF voltage at the at least one RF output port. The variable reactive elements may be variable capacitances, variable inductances, or both. Document WO 2004/098076 discloses another prior art example of a transceiver with automatic impedance matching capabilities.

The present invention is set out in the independent claims, with some optional features set out in the claims dependent thereto.

### Brief Description of the Drawings

FIG. 1 is a schematic block diagram of a mobile wireless communications device in accordance with one exemplary aspect.

FIG. 2 .is a schematic block diagram of the non-directional coupler illustrated in FIG. 1.

FIG. 3 is a schematic block diagram of another embodiment of the non-directional coupler illustrated in FIG. 1.

FIG. 4 is a more detailed schematic block diagram of the mobile wireless communications device illustrated in FIG. 1.

FIG. 5 is a flowchart illustrating a method for operating a mobile wireless communications device in accordance with one exemplary aspect.

FIG. 6 is a front view of a mobile wireless communications device in accordance with another exemplary aspect.

FIG. 7 is a schematic block diagram illustrating additional components that may be included in the mobile wireless communications device illustrated in FIG. 6.

### Detailed Description

The present description is made with reference to the accompanying drawings, in which various embodiments are shown. However, many different embodiments may be used, and thus the description should not be construed as limited to the embodiments set forth herein. Rather, these embodiments are provided so that this disclosure will be thorough and complete. Like numbers refer to like elements throughout and prime notation is used to indicate similar elements in alternative embodiments.

In accordance with one exemplary aspect, a mobile wireless communications device comprises a portable housing, a transmitter carried by the portable housing and configured to modulate an input signal, and an adjustable impedance matching network carried by the portable housing and coupled downstream from the transmitter. An antenna may be carried by the portable housing and may be coupled downstream from the adjustable impedance matching network. A non-directional coupler may be carried by the portable housing and may be coupled between the adjustable impedance matching network and the antenna. A feedback receiver may be carried by the portable housing and may be coupled to the non-directional coupler to generate a feedback signal. A controller may be carried by the portable housing and may be configured to control the adjustable impedance matching network based upon the input signal and the feedback signal.

An advantage of the mobile wireless communications device is that the antenna impedance matching does not require the use of directional couplers. Instead, a non-directional coupler is used. A non-directional coupler operates over a wide frequency band of operation. This is particularly advantageous when the transmitter is a multi-frequency band transmitter. The non-directional coupler may comprise a signal path conductor and a feedback path conductor inductively coupled thereto. Alternatively, the non-directional coupler may comprise a signal path conductor and a resistive load coupled thereto. A high resistance couples an insignificantly small fraction of the transmitted power to the feedback path.

The controller may be configured to compare the input signal to the transmitter to the feedback signal in at least one iteration to determine at least one difference therebetween, and adjust an impedance of the adjustable impedance matching based upon the at least one difference. The at least one iteration may comprise a plurality of iterations, and the controller may be further configured to add a correction value to the input signal in each iteration. The controller may be configured to calculate correction values based on a least means square (LMS) algorithm.

The feedback path may comprise a low noise amplifier (LNA) followed by a mixer driven by a phase locked loop (PLL) independent of the PLL driving the mixer in the transmitter. Analog baseband and digital baseband blocks follow an IQ mixer output and furnish the feedback signal in the digital format to the controller. Having an independent PLL for the feedback receiver allows the feedback transmit signal to be placed at an IF frequency and separate the impairments added by the feedback receiver in the frequency domain. A second down-conversion in the receiver digital block can down-convert the feedback transmit signal to a zero-IF while translating the impairments due to the receiver (e.g., offsets) at the IF frequency. A low-pass filter can then isolate the feedback transmit signal and furnish it to the controller, thereby removing all impairments introduced by the feedback receiver.

The controller may comprise a delay circuit configured to delay the input signal so that the input signal and the feedback signal match up in time when compared. The delay circuit may be configured to implement a fixed delay corresponding to inherent delays of the transmitter and the feedback receiver, and a variable delay corresponding to variable environmental conditions.

The adjustable impedance matching network may comprise at least one variable capacitor. The wireless communications device may further comprise a signal receiver carried by the portable housing and coupled to the antenna. The transmitter may comprise a multi-frequency band transmitter.

A method aspect is for operating a mobile wireless communications device as described above. The method comprises generating an input signal to be modulated by the transmitter, and operating the feedback receiver to generate a feedback signal from the non-directional coupler. The adjustable impedance matching network may then be adjusted based upon the input signal and the feedback signal.

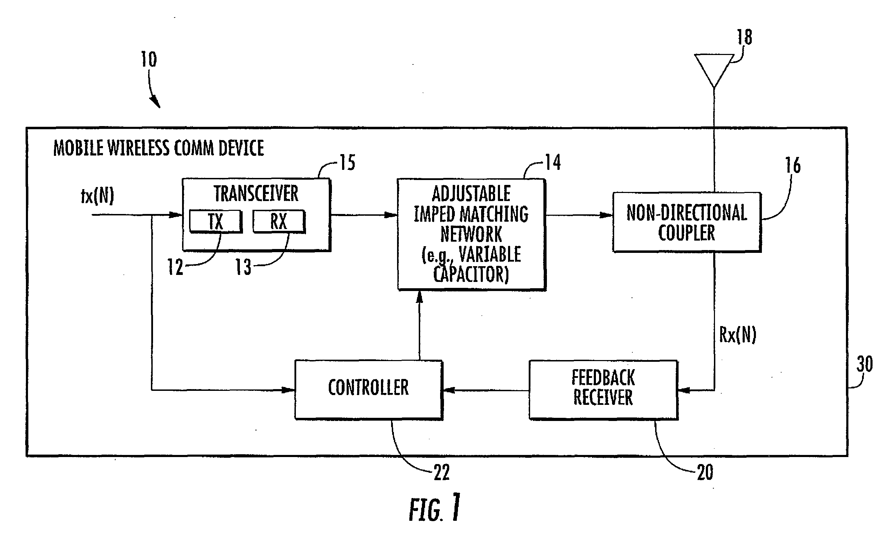

Referring initially to FIG. 1, a mobile wireless communications device **10** comprises a transmitter **12**, an adjustable impedance matching network **14**, a non-directional coupler **16**, an antenna **18**, a feedback receiver **20** and a controller **22**. All of these items are carried by a portable housing **30**. The mobile wireless communications device **10** may be a cellular telephone, for example.

When the mobile wireless communications device **10** is configured to operate in a full-duplex mode, the transmitter **12** is included as part of a transceiver **15**. The receiver **13** associated with the transceiver **15** is a signal receiver for receiving externally transmitted signals. In this configuration, the feedback receiver **20** is an additional receiver that is included within the mobile wireless communications device **10** to service the needs of the transmitter **12**, for example. Calibration and compensation are two examples of servicing the needs of the transmitter **12** as will be appreciated by those skilled in the art. A feedback receiver with an independent PLL can alleviate calibration and compensation needs in the receiver by offsetting the local oscillator (LO) for the receiver from the LO used in the transmitter, thereby separating the transmit feedback signal in frequency domain from the impairments added in the receiver.

When the mobile wireless communications device **10** is configured to operate in a half-duplex mode, there is a single receiver. In this configuration, the single receiver operates as the feedback receiver and the signal receiver. In this case calibration and compensation are two examples of servicing the needs of the receiver as will be appreciated by those skilled in the art.

Regardless of the mode of operation, i.e., full-duplex or half-duplex, the transmitter **12** is configured to modulate and transmit an input signal tx(n) . The adjustable impedance matching network **14** is coupled downstream from the transmitter **12**, and the antenna **18** is coupled downstream from the adjustable impedance matching network. The non-directional coupler **16** is coupled between the adjustable impedance matching network **14** and the antenna **18**. The feedback receiver **20** is coupled to the non-directional coupler 16 to generate a feedback signal rx(n) . The controller **22** is configured to control the adjustable impedance matching network **14** based upon the input signal tx(n) and the feedback signal rx(n).

An advantage of using a non-directional coupler **16** is that it can operate over a wide band of operation, and its performance remains well controlled over temperature and frequency changes. This is not the case with directional couplers. For illustration purposes, the transmitter **12** may be a multi-frequency band transmitter that operates over a 2.4 GHz frequency band (i.e., approximately 2.4 to 2.483 GHz) and over a 5 GHz frequency band (i.e., approximately 4.9 to 6 GHz). Depending on the intended application, the transmitter 12 may operate over other frequency bands, as readily appreciated by those skilled in the art.

Using the above example, the same non-directional coupler **16** can operate over both the 2.4 GHz frequency band and the 5 GHz frequency band. In sharp contrast, two directional couplers would be needed in place of a single non-directional coupler **16**, one for the 2.4 GHz frequency band and one for the 5 GHz frequency band. Consequently, the use of directional couplers increases the complexity and adds to the cost of such devices.

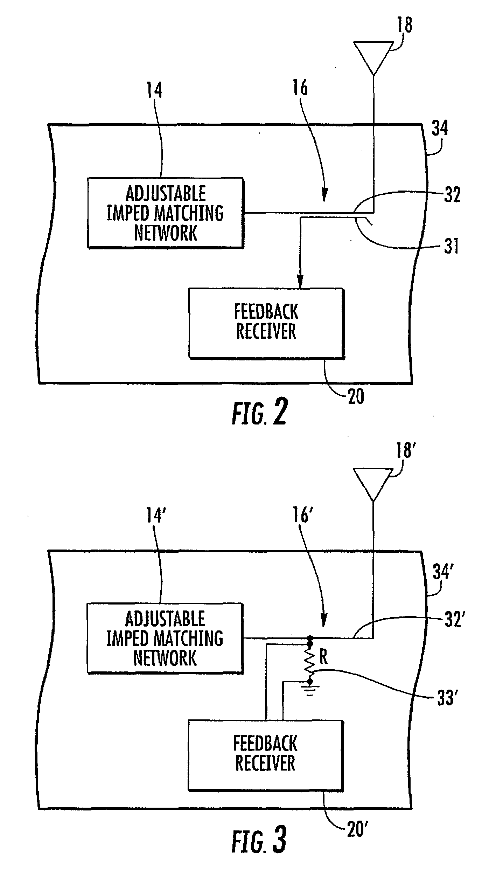

The non-directional coupler **16** directs a small amount of signal energy from the antenna 18 to the feedback receiver **20**. In one embodiment, the non-directional coupler **16** is configured as a wire trace **31** that is parasitically (e.g., inductively, electromagnetically) coupled to another wire trace **32** functioning as a signal path between the adjustable impedance matching network **14** and the antenna **18**, as illustrated in FIG. 2. Both of these wire traces **31**, 32 may be formed on a printed circuit board (PCB) **34**.

In another embodiment, the non-directional coupler 16' is a resistive load **33**' coupled to the signal path **32**', as illustrated in FIG. 3. The resistive load **33**' may have a value within a range of about 5K to 10K ohms, for example. The resistive load **33**' and the signal path **32**' may also be formed on a PCB **34**'.

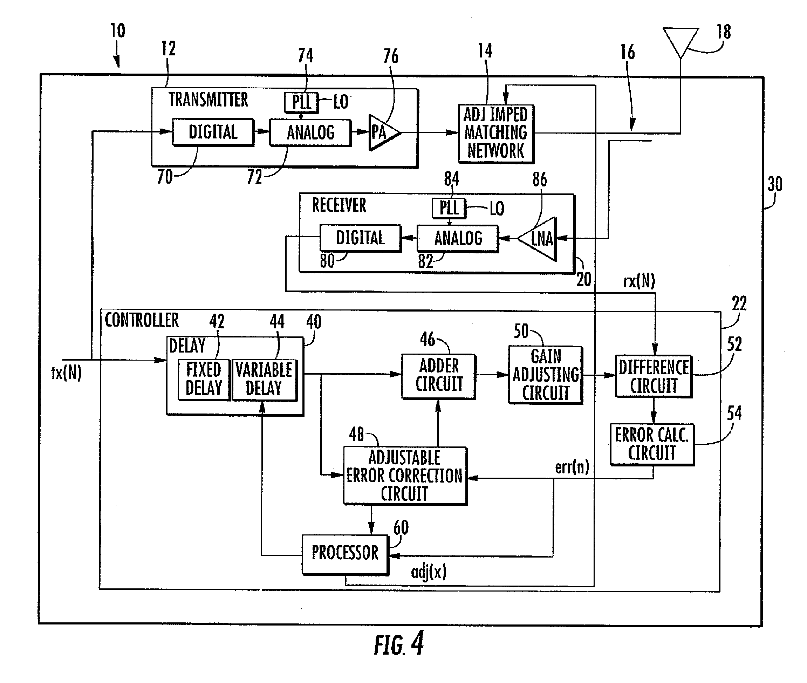

Referring now to FIG. 4, the mobile wireless communications device **10** will be discussed in greater detail. Starting with the controller **22**, a copy of the distorted signal at the antenna **18** is compared with a delayed version of the same signal **tx(n)** prior to transmission and without distortion. The differences between the two versions of the same signal are then used to estimate the impedance mismatch at the antenna **18**.

The controller **22** thus receives two signals: the signal to be transmitted tac(n) without distortion (i.e., the input signal) and a copy of the transmitted signal with distortion (i.e., the feedback signal **rx(n)).** A delay circuit **40** is used to delay the input signal **tx(n).** The delay is necessary for the feedback signal **rx(n)** to be aligned with the input signal **tx(n)** when compared.

The illustrated delay circuit **40** includes a fixed delay circuit portion **42** and a variable delay circuit portion 44**.** The fixed delay circuit portion **42** accounts for the inherent delays of the transmitter **12** and the feedback receiver **20**. The variable delay circuit portion **44** accounts for environmental conditions, such as operating temperature variations, for example. In particular, the analog transmit section **72** within the transmitter **12** and the analog receive section **82** within the feedback receiver **20** are effected by temperature variations. The variable delay circuit portion **44** may be under the control of a processor **60**, which includes a temperature sensor, for example. Alternatively, the temperature sensor may be separate from the processor **60**. The delay can also change with the change of filter corner frequency of filters in the baseband part of the transmitter as well as the receiver to support multistandard radio configurations or AGC settings within a single standard.

The delayed input signal is applied to an adder circuit **46** and to an adjustable error correction circuit **48**. The adjustable error correction circuit **48** is to compensate for the distortion in the feedback signal rx(n). On an initial pass, the estimated distortion provided by the adjustable error correction circuit **48** may be zero or a preset amount.

The adder circuit **46** combines the delayed input signal with the estimated distortion from the adjustable error correction circuit **48**. This combined signal is provided to a gain adjusting circuit **50**. The gain adjusting circuit **50** prevents clipping of the combined signal. If the delayed input signal with the estimated distortion has too much gain, then the gain is reduced.

The "clipped" delayed input signal with the estimated distortion is provided to a difference circuit **52**. Also provided to the difference circuit **52** is the feedback signal **rx(n).** The output from the difference circuit **52** is a difference signal between the delayed input signal with the estimated distortion, and the feedback signal **rx(n)** that includes the actual distortion at the antenna **18**.

The difference signal is applied to an error calculation circuit **54**. The error correction circuit **54** generates an error signal **err(n)** that is provided to the adjustable error correction circuit **48**. The adjustable error correction circuit **54** contains logic to compute averaged minimum and maximum errors. The error signal **err(n)** is a complex number, for example.

Based on the sign of the complex number, the error correction circuit **48** either increases or decreases the estimated distortion being applied to the delayed input signal while rotating it in the right direction to force the error towards zero. The goal is to iteratively adjust the estimated distortion until the error signal **err(n)** is zero in mean or least square sense or is close to zero. The error correction circuit **48** adjusts the estimated distortion using a steepest descent algorithm, such as a least means square (LMS) algorithm, for example. Under normal operation, the estimated distortion may be estimated off-line. The delayed input signal with the estimated distortion and the feedback signal **rx(n**) are compared frequently, such as in the millisecond range, for example.

The estimated distortion as determined by the error correction circuit **48** is applied to the processor 60. The processor **60** then generates an adjustment signal **adj(n)** to adjust the impedance of the adjustable impedance matching network **14**. The adjustable impedance matching network **14** may include a DC-DC converter, a digital-to-analog converter and a tuning device, for example. The tuning device may be a varactor (i.e., a variable capacitor), for example, that can be programmed.

A value of the varactor can be change by changing a voltage applied thereto. The adjustable impedance matching network **14** may include an SPI port, and the voltage is changed by writing a digital code to the SPI port. The digital code received at the SPI port is converted from digital to analog. At an analog value, the proper voltage is applied to the varactor. As long as the error signal **err(n)** approaches zero, the estimated distortion is reduced or removed by the adjustable impedance matching network **14**.

The processor **60** also uses the **err(n)** signal to accommodate temperature based delay changes between the input signal **tx(n)** and the feedback signal **rx(n).** As noted above, the analog transmit section **72** within the transmitter **12** and the analog receive section 82 within the feedback receiver **20** are effected by temperature variations.

A mathematical description of one implementation follows. The error signal e(n) = d(n) - y(n), where the received signal y(n) = tx(n) (1 + w1(n)) is the distorted signal obtained from the ideal signal tx(n). The received signal is the desired response d(n) which has seen the real distortion from the antenna impedance mismatch. The gradient of error signal with respect to w1 is -tx*(n), where subscript * denotes a complex conjugation. The update equation is therefore w1 (n+1) = wl(n) + mu e (n) tx*(n). The variable w1 will finally converge to the value of the antenna mismatch as the error becomes zero in a statistical sense. Several other implementations are possible with the same basic concept.

Another advantage of using a processor **60** is that software changes can be made to accommodate design and performance changes that may be necessary during operation of the controller **22**. Without the processor **60**, performance changes would have to be implemented via hardware. Hardware changes can be costly and time consuming as compared to software changes.

The transmitter **12** includes a digital transmit section **70**, an analog transmit section **72** coupled to the digital transmit section, and a power amplifier 76 coupled to the analog transmit section. The digital transmit section **70** performs sampling rate conversion and pre-compensates for the analog imperfections that are encountered in the analog transmit section **72**. In the analog transmit section **72**, the pre-compensated signals are converted from digital to analog, up-converted in frequency and pre-amplified prior to the power amplifier **76**.

The non-directional coupler **16** captures a portion of the electro-magnetic energy for down-conversion and analog-to-digital conversion in the feedback receiver **20**. The feedback receiver **20** includes a low noise power amplifier **86**, an analog receive section **82** coupled to the low noise power amplifier, and a digital receive section **80** coupled to the analog receive section. The power amplifier **86** is used for gain, and to also isolate the antenna **18** from the local oscillator used in the down-conversion within the analog receive section **82**. The digital receive section **80** compensates for analog imperfections, such as DC offset and IQ mismatch.

Still referring to FIG. 4, the feedback receiver 20 has its own phase locked loop (PLL) **84**, and the transmitter 12 has its own phase locked loop PLL **74**. Any impairment created in the feedback receiver **20** is at a frequency offset from the impairment to be measured. The frequency offset is at an IF frequency instead of a 0 frequency, and this allows separation using the IF frequency. The frequency offset is removed in the digital receive section **80**, wherein a filter is used to remove the impairment that was caused in the feedback receiver 12. As a result, the communications device 10 is limited to the impairment that was created in the transmitter 12 so that the mismatch at the antenna **18** can be more accurately estimated using separate PLLs **74**, 84**.**

Alternatively, one PLL can drive both the transmitter **12** as well as the feedback receiver **20**. A disadvantage of a shared PLL is that any impairment in the signal at the antenna mismatch (as provided by the transmitter 12**)** would be passed to the analog/digital converter in the feedback receiver **20**. It is difficult to distinguish between the impairment created by the feedback receiver **20** and from what is being measured. To compensate for this disadvantage, the feedback receiver **20** is calibrated so that it is not creating any noticeable addition to the impairment that is being measured.

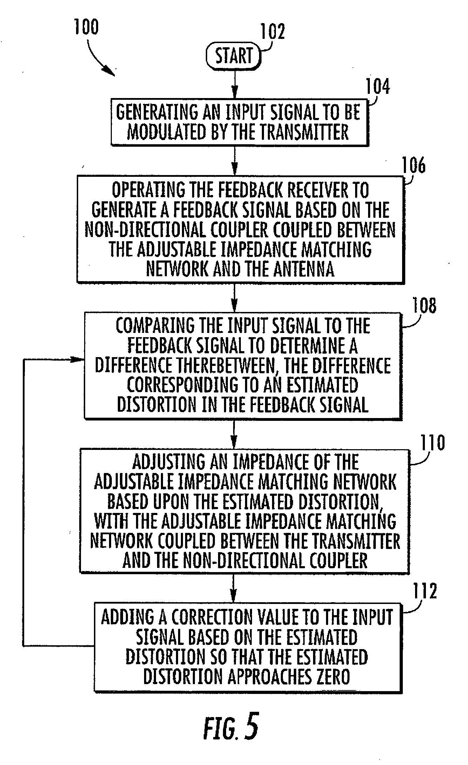

A flowchart **100** illustrating a method for operating a mobile wireless communications device 10 will now be discussed in reference to FIG. 5. From the start (Block **102**), the method comprises generating an input signal **tx(n)** to be modulated by the transmitter **12** at Block **104**. The feedback receiver is operated at Block **106** to generate a feedback signal **rx(n)** based on the non-directional coupler **16** coupled between the adjustable impedance matching network **14** and the antenna **18**.

The input signal **tx(n)** is compared to the feedback signal **rx(n)** at Block **108** to determine a difference therebetween. The difference corresponds to an estimated distortion in the feedback signal **rx(n).** An impedance of the adjustable impedance matching network **14** is adjusted at Block 110 based upon the estimated distortion. The adjustable impedance matching network **14** is coupled between the transmitter 12 and the non-directional coupler 16. A correction value is added to the input signal **tx(n)** based on the estimated distortion so that the estimated distortion approaches zero at Block **112**. Since the goal is to iteratively adjust the estimated distortion until the error signal is zero or is close to zero, the output of Block **112** loops back to Block **108** to repeat the process.

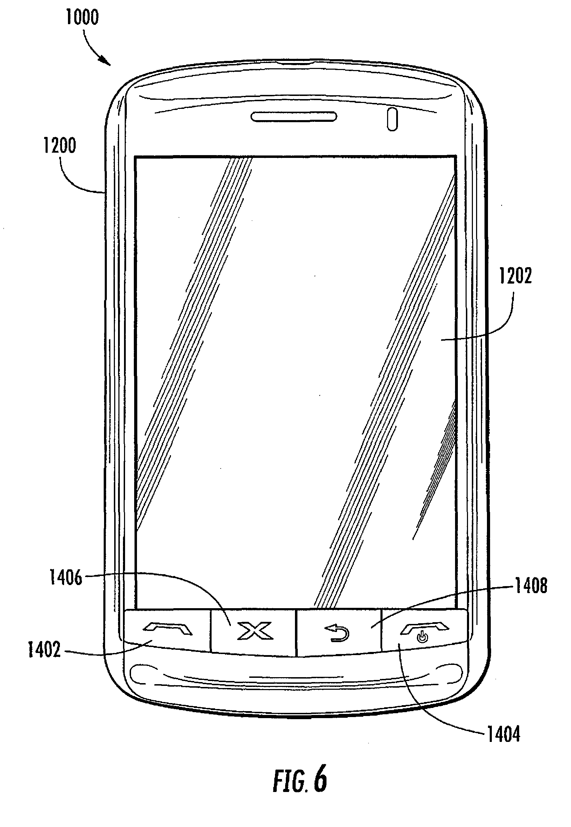

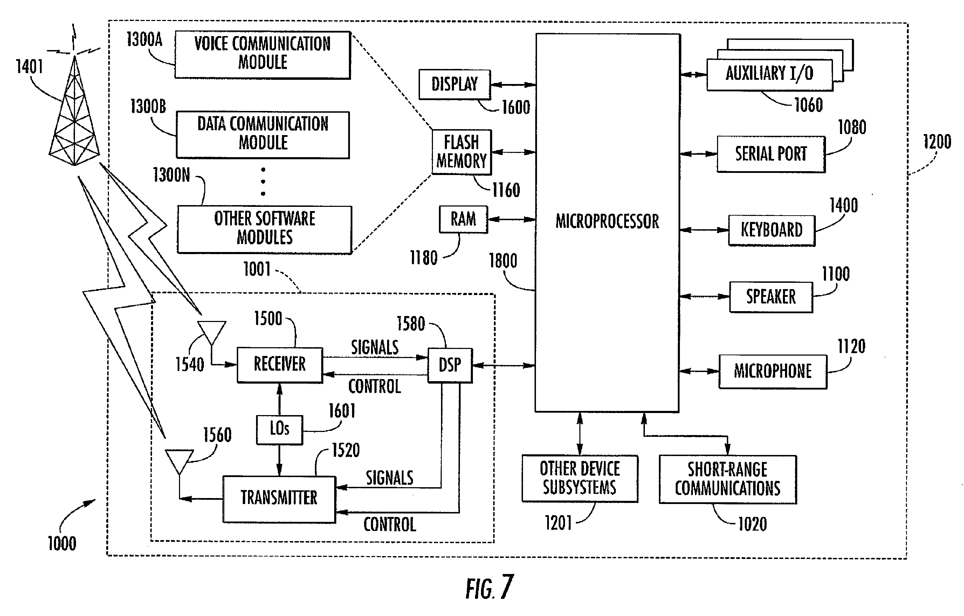

Exemplary components that may be used in various embodiments of the above-described mobile wireless communications device are now described with reference to an exemplary mobile wireless communications device **1000** shown in FIGS. 6 and 7.

The mobile wireless communications device **1000** illustratively includes a portable housing **1200**, a keypad 1400 and an output device **1600**. The output device shown is a display **1600**, which may comprise a full graphic LCD. In some embodiments, display **1600** may comprise a touch-sensitive input and output device. Other types of output devices may alternatively be utilized. The keypad **1400** includes a plurality of control keys including an "off hook" (i.e., initiate phone call) key **1402**, an "on hook" (i.e., discontinue phone call) key **1404**, a menu key **1406**, and a return or escape key **1408**.

A processing device **1800** is contained within the housing **1200** and is coupled between the keypad **1400** and the display **1600**. The processing device **1800** controls the operation of the display 1600, as well as the overall operation of the mobile device **1000**, in response to actuation of keys on the keypad **1400** by the user. In some embodiments, keypad **1400** may comprise a physical keypad or a virtual keypad (e.g., using a touch-sensitive interface) or both.

The housing **1200** may be elongated vertically, or may take on other sizes and shapes (including clamshell housing structures, for example). The keypad **1400** may include a mode selection key, or other hardware or software for switching between text entry and telephony entry.

In addition to the processing device **1800**, other parts of the mobile device **1000** are shown schematically in FIG. 7. These include a communications subsystem **1001**; a short-range communications subsystem **1020**; the keypad 1400 and the display **1600**, along with other input/output devices **1060**, **1080**, **1100** and **1120**; as well as memory devices **1160**, **1180** and various other device subsystems **1201**. The mobile device **1000** may comprise a two-way RF communications device having voice and data communications capabilities. In addition, the mobile device **1000** may have the capability to communicate with other computer systems via the Internet.

Operating system software executed by the processing device **1800** may be stored in a persistent store, such as the flash memory **1160**, but may be stored in other types of memory devices, such as a read only memory (ROM) or similar storage element. In addition, system software, specific device applications, or parts thereof, may be temporarily loaded into a volatile store, such as the random access memory (RAM) **1180**. Communications signals received by the mobile device may also be stored in the RAM **1180**.

The processing device **1800**, in addition to its operating system functions, enables execution of software applications or modules **1300A**-**1300N** on the device **1000**, such as software modules for performing various steps or operations. A predetermined set of applications that control basic device operations, such as data and voice communications **1300A** and **1300B**, may be installed on the device **1000** during manufacture. In addition, a personal information manager (PIM) application may be installed during manufacture. The PIM may be capable of organizing and managing data items, such as e-mail, calendar events, voice mails, appointments, and task items. The PIM application may also be capable of sending and receiving data items via a wireless network **1401**. The PIM data items may be seamlessly integrated, synchronized and updated via the wireless network **1401** with the device user's corresponding data items stored or associated with a host computer system.

Communication functions, including data and voice communications, are performed through the communications subsystem 1001, and possibly through the short-range communications subsystem. The communications subsystem **1001** includes a receiver **1500**, a transmitter **1520**, and one or more antennas **1540** and **1560**. In addition, the communications subsystem **1001** also includes a processing module, such as a digital signal processor (DSP) **1580**, and local oscillators (LOs) **1601**. The specific design and implementation of the communications subsystem **1001** is dependent upon the communications network in which the mobile device **1000** is intended to operate. For example, a mobile device **1000** may include a communications subsystem 1001 designed to operate with the Mobitex^{TM}, Data TAC^{TM} or General Packet Radio Service (GPRS) mobile data communications networks, and also designed to operate with any of a variety of voice communications networks, such as AMPS, TDMA, CDMA, WCDMA, PCS, GSM, EDGE, etc. Other types of data and voice networks, both separate and integrated, may also be utilized with the mobile device 1000. The mobile device 1000 may also be compliant with other communications standards such as GSM, 3G, UMTS, 4G, etc.

Network access requirements vary depending upon the type of communication system. For example, in the Mobitex and DataTAC networks, mobile devices are registered on the network using a unique personal identification number or PIN associated with each device. In GPRS networks, however, network access is associated with a subscriber or user of a device. A GPRS device therefore utilizes a subscriber identity module, commonly referred to as a SIM card, in order to operate on a GPRS network.

When required network registration or activation procedures have been completed, the mobile device **1000** may send and receive communications signals over the communication network **1401**. Signals received from the communications network 1401 by the antenna **1540** are routed to the receiver **1500**, which provides for signal amplification, frequency down conversion, filtering, channel selection, etc., and may also provide analog to digital conversion. Analog-to-digital conversion of the received signal allows the DSP **1580** to perform more complex communications functions, such as demodulation and decoding. In a similar manner, signals to be transmitted to the network **1401** are processed (e.g. modulated and encoded) by the DSP **1580** and are then provided to the transmitter **1520** for digital to analog conversion, frequency up conversion, filtering, amplification and transmission to the communication network **1401** (or networks) via the antenna **1560**.

In addition to processing communications signals, the DSP **1580** provides for control of the receiver **1500** and the transmitter **1520**. For example, gains applied to communications signals in the receiver **1500** and transmitter **1520** may be adaptively controlled through automatic gain control algorithms implemented in the DSP **1580**.

In a data communications mode, a received signal, such as a text message or web page download, is processed by the communications subsystem **1001** and is input to the processing device **1800**. The received signal is then further processed by the processing device **1800** for an output to the display **1600**, or alternatively to some other auxiliary I/O device **1060**. A device user may also compose data items, such as e-mail messages, using the keypad **1400** and/or some other auxiliary I/O device **1060**, such as a touchpad, a rocker switch, a thumb-wheel, or some other type of input device. The composed data items may then be transmitted over the communications network **1401** via the communications subsystem **1001**.

In a voice communications mode, overall operation of the device is substantially similar to the data communications mode, except that received signals are output to a speaker **1100**, and signals for transmission are generated by a microphone **1120**. Alternative voice or audio I/O subsystems, such as a voice message recording subsystem, may also be implemented on the device **1000**. In addition, the display **1600** may also be utilized in voice communications mode, for example to display the identity of a calling party, the duration of a voice call, or other voice call related information.

The short-range communications subsystem enables communication between the mobile device **1000** and other proximate systems or devices, which need not necessarily be similar devices. For example, the short-range communications subsystem may include an infrared device and associated circuits and components, or a Bluetooth^{TM} communications module to provide for communication with similarly-enabled systems and devices.

Many modifications and other examples of the disclosure will come to the mind of one skilled in the art having the benefit of the teachings presented in the foregoing descriptions and the associated drawings. Therefore, it is understood that the disclosure is not to be limited to the specific examples disclosed, and that modifications may be made within the scope of the appended claims.

## Claims

1. A mobile wireless communications device (30) comprising:
a portable housing (30);
a transmitter (12) carried by said portable housing and configured to modulate an input signal;
an adjustable impedance matching network (14) carried by said portable housing and coupled downstream from said transmitter;
an antenna (18) carried by said portable housing and coupled downstream from said adjustable impedance matching network;
a signal receiver (13) carried by said portable housing and coupled to said antenna;
a non-directional coupler (36) carried by said portable housing and coupled between said adjustable impedance matching network and said antenna;
a feedback receiver (20) carried by said portable housing and coupled to said non-directional coupler to generate a feedback signal, and comprising a local oscillator coupled thereto; and
a controller (22) carried by said portable housing and configured to control said adjustable impedance matching network based upon the input signal and the feedback signal.

2. The wireless communications device according to Claim 1 wherein said non-directional coupler comprises a signal path conductor and a feedback path conductor inductively coupled thereto.

3. The wireless communications device according to Claim 1 wherein said non-directional coupler comprises a signal path conductor and a resistive load coupled thereto.

4. The wireless communications device according to Claim 1 wherein said controller is configured to compare the input signal to the feedback signal in at least one iteration to determine at least one difference therebetween, and adjust an impedance of said adjustable impedance matching based upon the at least one difference.

5. The wireless communications device according to Claim 4 wherein the at least one iteration comprises a plurality of iterations; and wherein said controller is further configured to add a correction value to the input signal in each iteration.

6. The wireless communications device according to Claim 5 wherein said controller is configured to calculate correction values based on a least means square (LMS) algorithm.

7. The wireless communications device according to Claim 4 wherein said controller comprises a delay circuit configured to delay the input signal so that the input signal and the feedback signal match up in time when compared.

8. The wireless communications device according to Claim 7 wherein said delay circuit is configured to implement a fixed delay corresponding to inherent delays of said transmitter and said feedback receiver, and a variable delay corresponding to variable environmental conditions.

9. The wireless communications device according to Claim 1 wherein said adjustable impedance matching network comprises at least one variable capacitor.

10. A method for operating a mobile wireless communications device (10) comprising a transmitter (12), an adjustable impedance matching network (14) coupled downstream from the transmitter, an antenna (18) coupled downstream from the adjustable impedance matching network, a signal receiver (13) coupled to the antenna, a non-directional coupler (16) coupled between the adjustable impedance matching network and the antenna, and a feedback receiver (20) coupled to the non-directional coupler, wherein the feedback receiver comprises a local oscillator coupled thereto, the method comprising the steps of:
generating an input signal to be modulated by the transmitter;
operating the feedback receiver independent of the signal receiver to generate a feedback signal from the non-directional coupler, the feedback receiver a local oscillator coupled thereto; and
adjusting the adjustable impedance matching network based upon the input signal and the feedback signal.

11. The method according to Claim 10 wherein the non-directional coupler comprises a signal path conductor and a feedback path conductor inductively coupled thereto.

12. The method according to Claim 10 wherein the non-directional coupler comprises a signal path conductor and a resistive load coupled thereto.

13. The method according to Claim 10 further comprising comparing the input signal to the feedback signal in at least one iteration to determine at least one difference therebetween; and wherein the adjusting comprises adjusting an impedance of the adjustable impedance matching based upon the at least one difference.

14. The method according to Claim 13 wherein the at least one iteration comprises a plurality of iterations; and further comprising adding a correction value to the input signal in each iteration.

## Patentansprüche

1. Mobile Drahtloskommunikationsvorrichtung (30) mit:
einem tragbaren Gehäuse (30),
einem Sender (12), der von dem tragbaren Gehäuse getragen wird und dazu konfiguriert ist, ein Eingabesignal zu modulieren,
einem justierbaren Impedanzanpassungsnetz (14), das von dem tragbaren Gehäuse getragen wird und von dem Sender nachgeschaltet gekoppelt ist,
einer Antenne (18), die von dem tragbaren Gehäuse getragen wird und von dem justierbaren Impedanzanpassungsnetz nachgeschaltet gekoppelt ist,
einem Signalempfänger (13), der von dem tragbaren Gehäuse getragen wird und an die Antenne gekoppelt ist,
einem ungerichteten Koppler (16), der von dem tragbaren Gehäuse getragen wird und zwischen dem justierbaren Impedanzanpassungsnetz und der Antenne gekoppelt ist,
einem Rückkopplungsempfänger (20), der von dem tragbaren Gehäuse getragen wird und an den ungerichteten Koppler gekoppelt ist, um ein Rückkopplungssignal zu erzeugen, mit einem daran gekoppelten lokalen Oszillator und
einer Steuerung (22), die von dem tragbaren Gehäuse getragen wird und dazu konfiguriert ist, das justierbare Impedanzanpassungsnetz auf Grundlage des Eingabesignals und des Rückkopplungssignals zu steuern.

2. Drahtloskommunikationsvorrichtung nach Anspruch 1, wobei der ungerichtete Koppler einen Signalpfadleiter und einen Rückkopplungspfadleiter aufweist, der induktiv daran gekoppelt ist.

3. Drahtloskommunikationsvorrichtung nach Anspruch 1, wobei der ungerichtete, Koppler einen Signalpfadleiter und eine Widerstandslast aufweist, die daran gekoppelt ist.

4. Drahtloskömmunikationsvorrichtung nach Anspruch 1, wobei die Steuerung dazu konfiguriert ist, das Eingabesignal mit dem Rückkopplungssignal in mindestens einer Iteration zu vergleichen, um mindestens einen Unterschied dazwischen zu bestimmen und eine Impedanz der justierbaren Impedanzanpassung auf Grundlage des mindestens einen Unterschieds zu justieren.

5. Drahtloskommunikationsvorrichtung nach Anspruch 4, wobei die mindestens eine Iteration eine Vielzahl an Iterationen aufweist und wobei die Steuerung ferner dazu konfiguriert ist, in jeder Iteration dem Eingabesignal einen Korrekturwert hinzuzufügen.

6. Drahtloskommunikationsvorrichtung nach Anspruch 5, wobei die Steuerung dazu konfiguriert ist, Korrekturwerte auf Grundlage eines LMS-Algorithmus, 'Least-Means-Square'-Algorithmus, zu berechnen.

7. Drahtloskommunikationsvorrichtung nach Anspruch 4, wobei die Steuerung eine Verzögerungsschaltung aufweist, die dazu konfiguriert ist, das Eingabesignal zu verzögern, so dass das Eingabesignal und das Rückkopplungssignal in der Zeit übereinstimmen, wenn sie verglichen werden.

8. Drahtloskommunikationsvorrichtung nach Anspruch 7, wobei die Verzögerungsschaltung dazu konfiguriert ist, eine feste Verzögerung, die inhärenten Verzögerungen des Senders und des Rückkopplungsempfängers entspricht, und eine variable Verzögerung einzuführen, die veränderlichen Umgebungsbedingungen entspricht.

9. Drahtloskommunikationsvorrichtung nach Anspruch 1, wobei das justierbare Impedanzanpassungsnetz mindestens einen variierbaren Kondensator aufweist.

10. Verfahren zum Betreiben einer mobilen Drahtloskommunikationsvorrichtung (10) mit einem Sender (12), einem justierbaren Impedanzanpassungsnetz (14), das von dem Sender nachgeschaltet gekoppelt ist, einer Antenne (18), die von dem justierbaren Impedanzanpassungsnetz nachgeschaltet gekoppelt ist, einem Signalempfänger (13), der an die Antenne gekoppelt ist, einem ungerichteten Koppler (16) zwischen dem justierbaren Impedanzanpassungsnetz und der Antenne und einem Rückkopplungsempfänger (20), der mit dem ungerichteten Koppler gekoppelt ist, wobei der Rückkopplungsempfänger einen daran gekoppelten lokalen Oszillator aufweist, wobei das Verfahren die folgenden Schritte aufweist:
Erzeugen eines von dem Sender zu modulierenden Eingabesignals,
von dem Signalempfänger unabhängiges Betreiben des Rückkopplungsempfängers, um von dem ungerichteten Koppler ein Rückkopplungssignal zu erzeugen, wobei der Rückkopplungsempfänger einen dran gekoppelten lokalen Oszillator, und
Justieren des justierbaren Impedanzanpassungsnetzes auf Grundlage des Eingabesignals und des Rückkopplungssignals.

11. Verfahren nach Anspruch 10, wobei der ungerichtete Koppler einen Signalpfadleiter und einen Rückkopplungspfadleiter aufweist, der induktiv daran gekoppelt ist.

12. Verfahren nach Anspruch 10, wobei der ungerichtete Koppler einen Signalpfadleiter und eine Widerstandslast aufweist, die daran gekoppelt ist.

13. Verfahren nach Anspruch 10 ferner mit Vergleichen des Eingabesignals mit dem Rückkopplungssignal in mindestens einer Iteration, um mindestens einen Unterschied dazwischen zu bestimmen, und wobei das Justieren ein Justieren einer Impedanz der justierbaren Impedanzanpassung auf Grundlage der mindestens einen Differenz aufweist.

14. Verfahren nach Anspruch 13, wobei die mindestens eine Iteration eine Vielzahl an Iterationen aufweist, und ferner mit Hinzuzufügen eines Korrekturwertes an das Eingabesignal in jeder Iteration.

## Revendications

1. Dispositif de communication mobile sans fil (10) comprenant :
un boîtier portatif (30) ;
un émetteur (12) supporté par ledit boîtier portatif et configuré pour moduler un signal d'entrée ;
un réseau ajustable d'adaptation d'impédance (14) supporté par ledit boîtier portatif et couplé en aval dudit émetteur ;
une antenne (18) supportée par ledit boîtier portatif et couplée en aval dudit réseau ajustable d'adaptation d'impédance ;
un récepteur de signaux (13) supporté par ledit boîtier portatif et couplé à ladite antenne ;
un coupleur non directionnel (16) supporté par ledit boîtier portatif et couplé entre ledit réseau ajustable d'adaptation d'impédance et ladite antenne ;
un récepteur de rétroaction (20) supporté par ledit boîtier portatif et couplé audit coupleur non directionnel afin de produire un signal de rétroaction, et comprenant un oscillateur local qui y est couplé ; et
un contrôleur (22) supporté par ledit boîtier portatif et configuré pour commander ledit réseau ajustable d'adaptation d'impédance en fonction du signal d'entrée et du signal de rétroaction.

2. Dispositif de communication sans fil selon la revendication 1, dans lequel ledit coupleur non directionnel comprend un conducteur de trajet de signal et un conducteur de trajet de rétroaction qui lui est couplé inductivement.

3. Dispositif de communication sans fil selon la revendication 1, dans lequel ledit coupleur non directionnel comprend un conducteur de trajet de signal et une charge résistive qui lui est couplée.

4. Dispositif de communication sans fil selon la revendication 1, dans lequel ledit contrôleur est configuré pour comparer le signal d'entrée et le signal de rétroaction dans au moins une itération, afin de déterminer au moins une différence entre eux, et pour ajuster une impédance dudit réseau ajustable d'adaptation d'impédance en fonction de ladite au moins une différence.

5. Dispositif de communication sans fil selon la revendication 4, dans lequel ladite au moins une itération comprend une pluralité d'itérations ; et dans lequel ledit contrôleur est en outre configuré pour ajouter une valeur de correction au signal d'entrée à chaque itération.

6. Dispositif de communication sans fil selon la revendication 5, dans lequel ledit contrôleur est configuré pour calculer des valeurs de correction en fonction d'un algorithme des moindres carrés.

7. Dispositif de communication sans fil selon la revendication 4, dans lequel ledit contrôleur comprend un circuit à retard configuré pour retarder le signal d'entrée afin que le signal d'entrée et le signal de rétroaction se correspondent dans le temps lorsqu'ils sont comparés.

8. Dispositif de communication sans fil selon la revendication 7, dans lequel ledit circuit à retard est configuré pour mettre en oeuvre un retard fixe correspondant à des retards inhérents dudit émetteur et dudit récepteur de rétroaction, ainsi qu'un retard variable correspondant à des conditions variables de l'environnement.

9. Dispositif de communication sans fil selon la revendication 1, dans lequel ledit réseau ajustable d'adaptation d'impédance comprend au moins un condensateur variable.

10. Procédé de fonctionnement d'un dispositif de communication mobile sans fil (10) comprenant un émetteur (12), un réseau ajustable d'adaptation d'impédance (14) couplé en aval de l'émetteur, une antenne (18) couplée en aval du réseau ajustable d'adaptation d'impédance, un récepteur de signaux (13) couplé à l'antenne, un coupleur non directionnel (16) couplé entre le réseau ajustable d'adaptation d'impédance et l'antenne, et un récepteur de rétroaction (20) couplé audit coupleur non directionnel, le récepteur de rétroaction comprenant un oscillateur local qui lui est couplé, le procédé comprenant les étapes consistant à :
produire un signal d'entrée à moduler par l'émetteur ;
faire fonctionner le récepteur de rétroaction indépendamment du récepteur de signaux pour produire un signal de rétroaction à partir du coupleur non directionnel, le récepteur de rétroaction étant couplé à un oscillateur local ; et
ajuster le réseau ajustable d'adaptation d'impédance en fonction du signal d'entrée et du signal de rétroaction.

11. Procédé selon la revendication 10, dans lequel le coupleur non directionnel comprend un conducteur de trajet de signal et un conducteur de trajet de rétroaction qui lui est couplé inductivement.

12. Procédé selon la revendication 10, dans lequel le coupleur non directionnel comprend un conducteur de trajet de signal et une charge résistive qui lui est couplée.

13. Procédé selon la revendication 10, comprenant en outre l'étape consistant à comparer le signal d'entrée et le signal de rétroaction dans au moins une itération, afin de déterminer au moins une différence entre eux, et dans lequel l'étape d'ajustement comprend l'étape consistant à ajuster une impédance dudit réseau ajustable d'adaptation d'impédance en fonction de ladite au moins une différence.

14. Procédé selon la revendication 13, dans lequel ladite au moins une itération comprend une pluralité d'itérations ; et comprenant en outre l'étape consistant à ajouter une valeur de correction au signal d'entrée à chaque itération.
